# EUROPEAN PATENT SPECIFICATION

(11) **EP 3 419 173 B1**
(45) Date of publication and mention of the grant of the patent: **21.04.2021**
(21) Application number: 18178903.3
(22) Date of filing: 20.06.2018
(51) Int. Cl.: G01R 33/07, H03K 17/95, H03K 19/18

(54) **AN ELECTRICAL SWITCHING CIRCUIT, CORRESPONDING METHOD AND APPARATUS**
EIN ELEKTRISCHER SCHALTKREIS, ENTSPRECHENDES VERFAHREN UND VORRICHTUNG
CIRCUIT DE COMMUTATION ÉLECTRIQUE, PROCÉDÉ ET APPAREIL CORRESPONDANTS

(30) Priority: 20.06.2017 IT 201700068700
(43) Date of publication of application: 26.12.2018
(73) Proprietor: Illinois Tool Works Inc., Glenview, IL 60025 (US)
(72) Inventor: SCLIP, Marco, Glenview, IL 60025 (US); DEMSAR, Goran, Glenview, IL 60025 (US)
(74) Representative: HGF

(56) References cited:
- WO-A1-2007/132389
- US-A- 5 412 255
- US-A1- 2003 141 862
- US-A1- 2005 168 909
- US-A1- 2005 285 581
- US-A1- 2017 016 966

## Description

### Priority claim

This application claims priority from Italian Patent Application No. 102017000068700 filed on June 20, 2017.

### Technical field

The present description relates to electrical switching circuits, e.g. based on electromagnetic sensors or switches, such as Hall effect switches or magneto-resistive switches.

One or more embodiments may involve a switching circuit using an electromagnetic switch as a pin-to-pin replacement for a conventional reed switch.

### Technological background

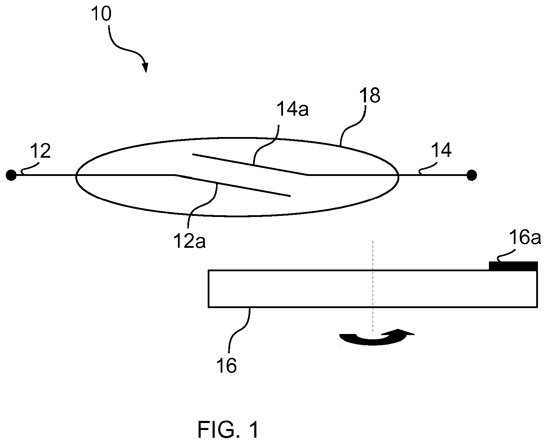

A reed switch is an electrical switch operated by a time varying magnetic field. As exemplified in Figure 1, a reed switch 10, *i.e*. a magnetomechanical switch, may have two electrical contacts or pins, 12 and 14, which are connected to flexible, ferromagnetic edges, 12a and 14a respectively, sealed in a housing 18, such as a glass envelope.

The edges 12a and 14a may be normally in contact or normally separated, depending on spring forces applied keeping them in position, and may react to a nearby magnetic field by opening or closing (respectively), e.g. a permanent magnet 16a placed on a rotating substrate 16 in Figure 1.

A number of blades may be attached to a rotor or an impeller (not illustrated in Figure 1) which in turn may be attached to the rotating substrate 16. The blades, submerged in a fluid, may be moved by the flow of the fluid, and the rotor may produce the rotation of the substrate 16.

As a result, the flow may move the permanent magnet 16a and the reed switch 10 may be used as a flowmeter.

It will be appreciated that, in Figure 1, the rotating substrate 16 is exemplified as rotating according to a certain axis, however it may be possible to consider different rotation axes, e.g. perpendicular to the depicted axis, or it may be possible to use an arrangement that may produce different types of motions, e.g. a harmonic motion.

Generally, the magnet 16a will be positioned on the substrate 16 in order to obtain interaction with the sensing unit, e.g. the reed switch 10, in a manner that is per se known in the art.

For example, a possible operation flow of a (normally open) reed switch 10 may include:
- when the magnet 16a is placed underneath the reed switch 10, the ferromagnetic material is magnetized and the two edges 12a and 14a contact, overcoming the spring forces that keep apart the edges 12a and 14a, and the switch 10 is closed (short circuit); and
- when the magnet 16a is moved away from the reed switch 10, the two edges 12a and 14a cease to be attracted and the spring forces of the edges 12a, 14a open the switch (open circuit).

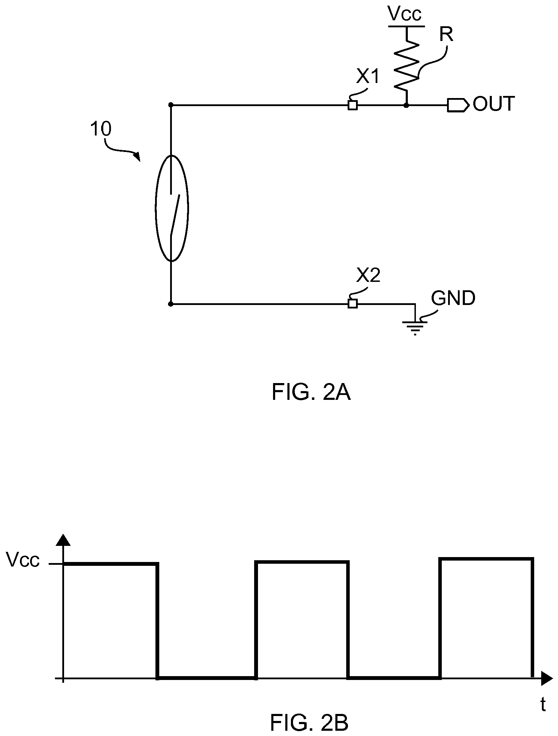

Figure 2A shows a possible switching circuit for use as a flowmeter, connecting a reed switch 10 to e.g. a processing unit (such as a microprocessor or a motherboard of a device) via terminals X1 and X2.

A voltage supply Vcc may be provided to the circuit at terminals X1 and terminal X2, the latter being connected to a ground terminal, GND. A pull-up resistor R may be also introduced, located between the voltage supply Vcc and terminal X1, and may be dimensioned (e.g. having a large resistance value) as to limit the current passing through the reed switch 10, thus possibly preserving the lifespan thereof.

Terminal X1 may be also connected to a terminal OUT, which may provide to the processing unit a digital signal, illustrated in Figure 2B, representative of the reed switch 10 switching between a close and an open condition. The signal at the terminal OUT may be a digital signal, i.e. a square wave, switching between a high logic level (e.g. when no magnetic field is present and the reed switch 10 is open - open circuit), e.g. corresponding substantially to the supply voltage value Vcc, and a low logic level corresponding substantially to a zero voltage (e.g. when the magnetic field is present and the reed switch 10 is closed - short circuit).

It will be appreciated that the terminal X1 is exemplified as being used both for power supply and for digital communication.

A solution involving a reed switch such as 10 may have one or more disadvantages: it may be vulnerable to mechanical stress which may lead to changes in sensitivity or, possibly, faults. Also, reed switches may exhibit a limited lifespan, and frequent changes may be due.

For this reason there are other known solutions, wherein an electromagnetic sensor or switch, such as a Hall effect switch or a magneto-resistive switch, may be used. These switches may exploit as well the magnetic field of a permanent magnet 16a attached to a rotating substrate 16 as described in the foregoing. However, the respective switching circuit differs from that of Figure 2A insofar as the electromagnetic switch is conventionally designed as a three-terminal device, whereas the magnetomechanical reed switch 10 operates as a two-terminal switch, connected only to terminals X1 and X2.

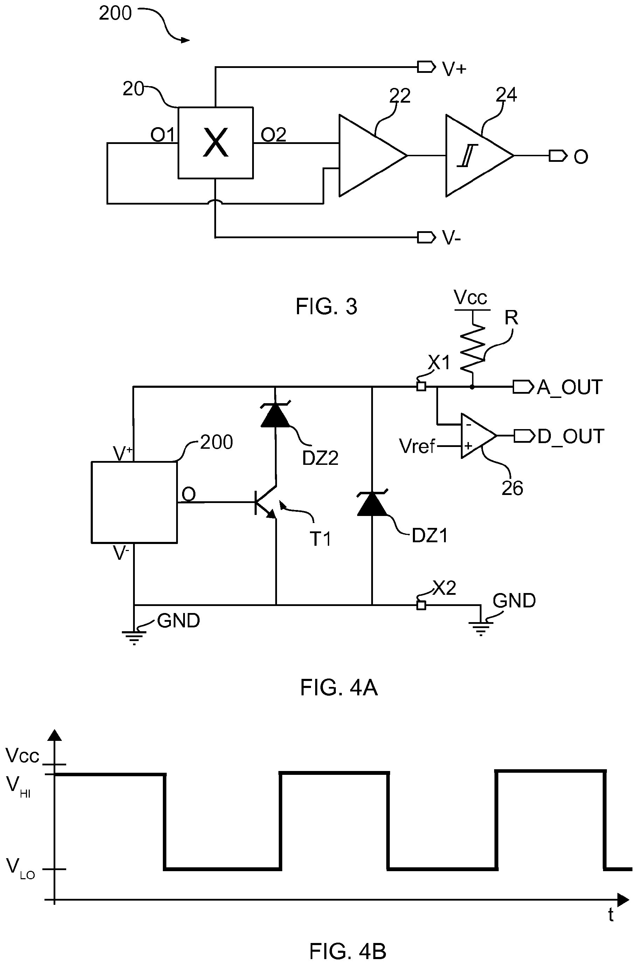

A non-limiting example of a conventional electromagnetic switch 200 based on an electromagnetic sensor 20 is shown in Figure 3, e.g. a Hall effect switch 200 based on a Hall effect sensor 20 or e.g. a magneto-resistive switch 200 based on an Anisotropic Magneto-Resistive (AMR) sensor 20, having a positive power supply terminal V+, an output terminal O and a negative power supply terminal V-. The electromagnetic switch 200 may therefore include the electromagnetic sensor 20 having four terminals: a positive and a negative power supply terminal connected to the positive and negative power supply terminals V+ and V- (representing a ground terminal) of the switch 200, respectively, and two outputs O1, O2, which may change its output voltage in response of a sensed magnetic field.

For example, in case of a Hall effect sensor 20, the terminals O1, O2 may be connected to a (differential) amplifier 22, which may increase voltage until saturation, based on the received output voltage. The output of the amplifier 22 may be connected to a Schmitt trigger 24, the output thereof being in turn connected to the terminal O. The Schmitt trigger 24 may thus translate an analogue output signal of the amplifier 22 into a digital output signal, by switching on and off according to a built-in hysteresis. Similarly, also a magneto-resistive switch 200 based on an Anisotropic Magneto-Resistive (AMR) sensor 20 may provide a digital output signal at the terminal O.

The electromagnetic switch 200, being a three-terminal switch, may not be used directly in a two-wire circuit as exemplified by Figure 2A. Certain changes may be involved in a switching circuit in order to obtain a two-wire connection (e.g. a connection only via terminals X1 and X2). An example of a two-wire switching circuit exploiting a Hall effect switch may be found in document CA 2009583 A1, which is exemplified in Figure 4A. The document discloses a circuit including a Hall effect switch 200 connected to a supply terminal (V+ to X1) and a ground terminal (V- to GND,X2), and an output terminal connected to a transistor T1 at its control terminal (O to base of T1). The current path of the transistor T1 may be placed between a Zener diode DZ2 and the ground terminal GND,X2, the Zener diode DZ2 having in turn its anode connected to the current path of the transistor T1 and its cathode connected to the supply terminal X1.

A further Zener diode DZ1 may be placed between the supply terminal X1 and ground terminal X2,GND in order to protect the circuit from e.g. overvoltage.

As exemplified in Figure 2A, also the circuit of Figure 4A may be connected to a processing unit through terminals X1 and X2, including:
- a voltage supply Vcc provided to the circuit at terminals X1 and X2,
- a pull-up resistor R located between the voltage supply Vcc and terminal X1,

- an analogue output terminal A_OUT located at terminal X1, and
- a comparator 26, receiving the voltage at terminal X1 to be compared with a reference voltage Vref, substantially V_{LO}, and providing as an output a digital output signal that will be fed to a digital output terminal D_OUT.

Such processing unit however differs from that of Figure 2A, insofar as the switching circuit of Figure 4A may produce analogue output signals (at A_OUT) which may not be compatible with certain digital logic inputs of e.g. the processing unit of Figure 2A. To produce a digital signal (at D_OUT) the comparator 26 may be added, introducing however a disadvantage of having an arrangement which is not immediately replaceable with a reed switch such as 10 of Figure 2A.

Figure 4B may represent a possible (analogue) output signal at the supply X1, A_OUT and ground X2 terminal of such a two-wire switching circuit exploiting a Hall effect switch 200, the output signal being a square signal changing from a high state V_{HI} to a low state V_{LO}, and vice versa.

During operation, when the output signal of the Hall effect switch 200 has a low voltage value, the transistor T1 is opened (i.e. non-conductive) and the Zener diode DZ2 does not affect the voltage value across the supply and ground terminals X1,X2: the output signal of the circuit is high, V_{HI}, being lower than the supply voltage value Vcc, that is Vcc minus a current consumption of the electromagnetic switch 200 and a voltage drop V_{R} across e.g. a pull-up resistor R (about V_{CC}-V_{R}).

On the contrary, when the output signal of the Hall effect switch 200 has a high voltage value, the transistor T1 becomes conductive and current flows through the Zener diode DZ2: the output signal of the switching circuit changes to a low state V_{LO}, substantially a Zener voltage of the Zener diode DZ2, the diode DZ2 being dimensioned such that the Zener voltage is higher than the voltage needed to supply the Hall effect switch 200, in order to keep the Hall effect switch 200 operating even when its output state is low.

Accordingly, such a switching circuit with Hall effect switch may be used to replace the reed switch 10 described in the foregoing with respect to Figures 1 and 2A, taking into account the differences to be introduced in e.g. a processing unit connected to the switching circuit, which may lead to changes (e.g. 26) on the processing unit part.

To sum up, the solution previously exemplified may include one or more drawbacks:
- again, due to the analogue output signal at A_OUT of the two-wire switching circuit, an additional element is needed, e.g. comparator 26, to acquire digital signal at D_OUT or an analogue input of a connected processing unit (e.g. a microcontroller) has to be used and a direct replacement of a reed switch cannot be operated; and
- the low voltage value V_{LO} is dictated by the Zener voltage, such as about 1.8 V. WO2007/132389A1 *does not overcome those drawbacks*

US 5412255 discloses a switch device suitable for use as active sensor in an automotive device.

US 2005/0285581A1 discloses an interface circuit of a Hall IC and a system for using it.

### Object and summary

The need is therefore felt for improved solutions that may facilitate overcoming the aforementioned drawbacks.

An object of one or more embodiments may be to obtain a pin-to-pin compatibility with e.g. a reed contact sensor flowmeter (reed switch) conventionally used in the market, i.e. a switching circuit that may be directly exchanged with a reed switch 10.

According to one or more embodiments, such an object may be achieved by means of an electrical switching circuit having the features set forth in the claims that follow.

The invention is defined according to independent apparatus claim 1 and corresponding independent method claim 12.

The claims are an integral portion of the disclosure of the invention as provided herein.

The switching circuit may be used as a replacement of the reed switch 10 without additional changes (hardware and/or software) on a processing unit connected to the electrical switching circuit, insofar as it may provide a digital output of the same type of e.g. a conventional reed switch.

One aspect of the invention relates to an electrical switching circuit including a first and a second terminal, the switching circuit includes an electromagnetic switch (e.g. of the type already disclosed in Figure 3) having a positive and a negative power supply terminal and an output terminal, wherein the negative power supply terminal being connected (e.g. directly) to the second terminal. An electronic switch connected (e.g. directly) between the first and second terminal, wherein the electronic switch switches between an opened (e.g. non-conductive) and a closed (e.g. conductive) condition as a function of a signal applied to a control terminal of the electronic switch.

Said control terminal of the electronic switch is connected (e.g. directly or indirectly via a pulse generator, which will be described in the following) to the output of the electromagnetic switch, thereby varying the resistance between the first and the second terminal. The electrical switching circuit includes electrical storage means connected (e.g. directly) between the positive and the negative power supply terminal of the electromagnetic switch.

A diode wherein its cathode is connected (e.g. directly) to the positive power supply terminal of the electromagnetic switch and its anode is connected (e.g. directly) to the first terminal, whereby:
- when the voltage between the first and the second terminal of the switching circuit is greater than the voltage between the positive and the negative power supply terminal of the electromagnetic switch, the diode is closed (i.e. made conductive) and the voltage between the first and the second terminal of the switching circuit supplies power to the electromagnetic switch and charges the electrical storage means, and
- when the voltage between the first and the second terminal of the switching circuit is smaller than the voltage between the positive and the negative power supply terminal of the electromagnetic switch, the diode is opened (i.e. made non-conductive) and the electrical storage means supply power to the electromagnetic switch; wherein the electrical switching circuit further comprises a pulse generator set between the output terminal of the electromagnetic switch and said control terminal of said electronic switch, wherein said pulse generator in configured to: detect a ring edge and/or a falling edge of the signal at the output terminal of the electromagnetic switch; and when a rising edge and/or a falling edge has been detected, generate a pulse applied to said control terminal of said electronic switch; wherein said pulse generator is moreover configured to: at a rising edge of the signal of the output terminal of the electromagnetic switch, generate a positive pulse at said control terminal of said electronic switch; and at a falling edge of the signal of the output terminal of the electromagnetic switch, generate a negative pulse at said control terminal of said electronic switch.

One embodiment relates to a corresponding apparatus such as a dishwasher, including an electrical switching circuit according to the embodiment and a processing unit (e.g. a microprocessor or a motherboard of a device) configured to:
- apply a voltage via a pull-up resistor to the first and a ground to the second terminal of the electrical switching circuit; and
- monitor the voltage at the first and the second terminal of the electrical switching circuit.

A method of monitoring a time varying magnetic field is defined in independent claim 12.

Such a solution may facilitate dealing with lower frequency operating conditions and/or situations wherein an electromagnetic switch included in the electrical switching circuit possibly retains indefinitely at its output a low voltage value. Such an object may be achieved e.g. by maintaining a valid state throughout operation even under these conditions.

### Brief description of several views of the drawings

One or more embodiments will now be described, by way of example only, with reference to the annexed figures, wherein:
- Figure 1 is exemplary of a conventional reed switch;
- Figure 2A is exemplary of a switching circuit including a reed switch, the output signal of the circuit being exemplified in Figure 2B;
- Figure 3 is exemplary of a conventional three-terminal electromagnetic switch;
- Figure 4A is exemplary of a two-wire switching circuit including a Hall effect sensor, the output signal of the two-wire switching circuit being exemplified in Figure 4B;
- Figure 5 is exemplary of electrical switching circuit including electromagnetic switch according to one example not covered by the invention; and
- Figures 6A, 6B are exemplary of signals generated by the electrical switching circuit according to one example.
Figure 7 is an electrical switching circuit including electromagnetic switch according to an embodiment; and
Figures 8a, 8b are exemplary of signals generated by the electrical switching circuit according to an embodiment.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

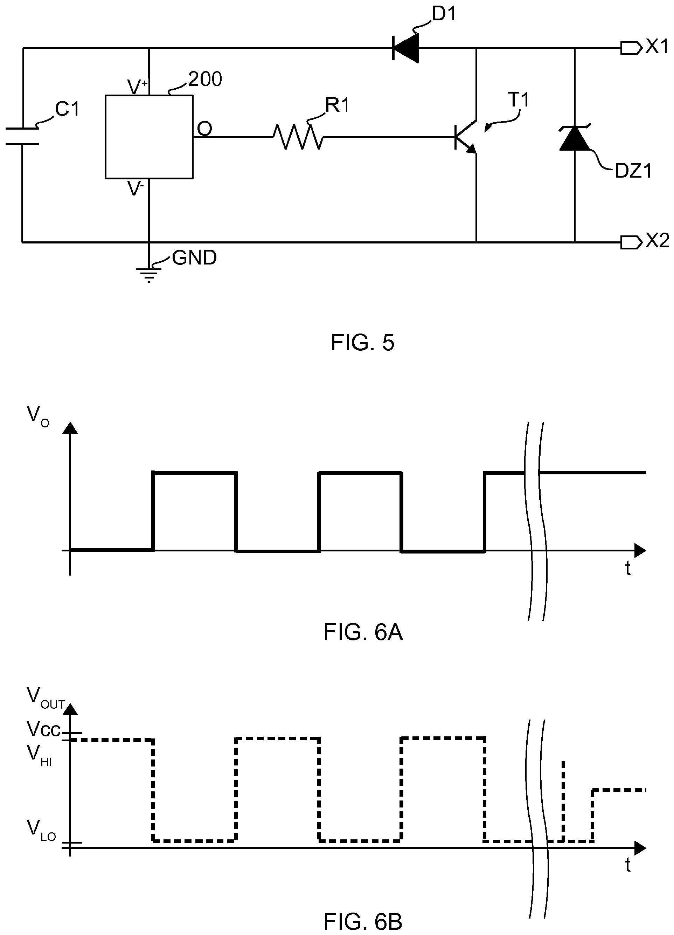

Figure 5 is exemplary of electrical switching circuit according to one example not covered by the invention, that may be used in an arrangement as disclosed previously in the description of Figures 1 and 2A, wherein the reed switch 10 may be substituted with an electrical switching circuit comprising an electromagnetic switch, such as a Hall effect switch or a magneto-resistive switch.

For example, in Figure 5, a positive terminal X1 and a negative terminal X2 (e.g. connected to ground GND) are provided to an electrical switching circuit, that may enable its connection with e.g. an external processing unit (such as a motherboard of an electric appliance or a microprocessor as previously described). It will be appreciated that also in this case the positive and negative terminals X1, X2 may be used both for power supply and digital communication, that is a (digital) output signal V_{OUT}, depicted in Figure 6B, may be generated thereacross.

An electromagnetic switch 200, e.g. of the type described in Figure 3, may have a positive V+ and a negative V- power supply terminal, the latter being connected to the negative terminal X2.

In the example considered, the signal provided by the output O of the electromagnetic switch 200 is used to control an electronic switch T1. For example, in the example considered, the electronic switch T1 may be a transistor, such as a npn bipolar transistor. In this case, the output O of the electromagnetic switch 200 may be connected to a resistance R1 which, in turn, may be connected to a base of bipolar transistor electronic switch T1. Accordingly, the resistance R1 may be set in series between the output O of the electromagnetic switch 200 and the control terminal of the electronic switch T1, in order to protect the electronic switch T1 from e.g. overcurrent.

Generally, e.g. in case the electronic switch T1 is implemented with a field effect transistor, the output 0 of the electromagnetic switch 200 may also be connected directly to the control terminal of the electronic switch T1.

An exemplary operation may include that:
- when the output signal V_{O} at the output O of the electromagnetic switch 200 (as depicted in Figures 6A) is low, i.e. substantially 0V, the electronic switch T1 may remain open, i.e. non-conductive,
- when the output signal V_{O} at the output O is high, the electronic switch T1 may be closed, i.e. it may become conductive.

In the example, a current path of the electronic switch T1 may connect e.g. directly the positive and negative terminals X1 and X2; as a consequence, when the electronic switch T1 is made conductive, the terminals X1 and X2 may be short-circuited.

Generally, also a resistor may be connected in series with the current path of the electronic switch T1, i.e. the resistance between the terminals X1 and X2 may be switched between a low and a high resistance value by means of the electronic switch T1, which may be detected by a control unit monitoring the voltage at the terminals X1 and X2.

Generally, in the low resistance state, the voltage at the terminal X1 and X2 may thus be smaller than the supply voltage requested by the electromagnetic switch 200.

Accordingly, in the example, electrical storage means C1 may be present, e.g. a capacitor or a rechargeable battery, that may be connected (e.g. directly) between the positive V+ and negative V- power supply terminals of the electromagnetic switch 200. For example, in various embodiments, the capacitor C1 may be between 1 and 10 uF, e.g. 2.2 uF.

In the example, also a diode D1 may be present, with its cathode connected (e.g. directly) to the positive V+ power supply terminal of the switch 200 and its anode connected (e.g. directly) to the positive terminal X1, which may facilitate preventing discharge of the electric storage means C1, e.g. via the electronic switch T1 when conductive.

Accordingly, in the example, the diode D1 may be configured such that:
- when the voltage between the terminals X1 and X2 is greater than the voltage between the positive V+ and negative V- power supply terminals of the electromagnetic switch 200, the diode D1 will close (i.e. become conductive) and the voltage applied to the terminals X1 and X2 may supply power to the electromagnetic switch 200 as well as charge the electrical storage means C1, and
- when the voltage between the terminals X1 and X2 is smaller than the voltage between the positive V+ and negative V- power supply terminals of the electromagnetic switch 200, the diode D1 will open (i.e. become non-conductive) and the electrical storage means C1 may supply power to the electromagnetic switch 200.

Accordingly, during the periods in which the electronic switch T1 is in the low resistance state, the electromagnetic switch 200 may still be supplied by the electrical storage means C1.

In the example, a Zener diode DZ1 may be present for limiting the supply voltage of the electromagnetic switch 200 (and thus the storage means C1) and/or the voltage at the electronic switch T1. For example, in the embodiment considered, the cathode of the Zener diode DZ1 is connected (e.g. directly) to the terminal X1 and the anode to the terminal X2.

Accordingly, when applying a current to the terminals X1 and X2 (e.g. by means of a pull-up resistor R connected to a supply voltage Vcc as described with respect to Figure 2A), the output signal V_{OUT} (between the terminals X1 and X2) may be a square wave, having values V_{HI} and V_{LO}. For example, as mentioned before, these voltages may be substantially the supply voltage Vcc and 0V, respectively.

It will be appreciated that, in the example, the output signal V_{OUT} will thus change state depending on the electromagnetic switch 200 output signal V_{O}, e.g.:
- when the electromagnetic switch 200 output signal V_{O} is low, the electronic switch T1 will be open (i.e. non-conductive, high resistance state) and no current may flow via the electronic switch T1; in this case the output signal V_{OUT} may have voltage value V_{HI} of about Vcc; and
- when the electromagnetic switch 200 output signal V_{O} is high, the electronic switch T1 may be closed (i.e. conductive) and terminals X1 and X2 may be placed in a low resistance state; for example, in case of a short-circuit, substantially all current flows via the closed electronic switch T1, providing about zero voltage drop across X1 and X2, and the output signal V_{OUT} may have voltage value V_{LO} of about 0V.

Advantages of the example as depicted in Figure 5 may include:
- having a digital 2-wire electrical switching circuit based on a electromagnetic switch 200 that can directly replace e.g. a reed switch (improvement with respect to the known analogue version); and/or
- the generated digital output (e.g. V_{OUT}) may have voltage levels being about 0V and about the supply voltage Vcc; and/or
- using two terminals, e.g. X1 and X2, wherein one terminal (X2) may be connected to ground GND and the other (X1) may be used both as a voltage supply and digital output, such as e.g. in the case of a reed switch.

Generally, in order to generate a digital signal, the voltage at the terminals X1 and X2 in the low resistance state does not have to be necessarily 0V, but a voltage lower than a threshold voltage of the following processing circuit monitoring the terminals X1 and X2, such as a Schmitt trigger at the input terminals of a microprocessor. Thanks to the use of the electrical storage means C1 and the diode D1, such a voltage may however be smaller than the supply voltage requested by the electromagnetic switch 200.

Conversely, in the analogue arrangement as depicted in Figures 4A and 4B, the output signal low voltage must be limited at a voltage higher than the working voltage of a electromagnetic switch 200: if the low voltage was to be lower than the working voltage or even about 0V, the electromagnetic switch 200 would lose power supply and possibly discontinue operation.

In the example, the electrical storage means C1 may be adjoined to facilitate overcoming the aforementioned issue, i.e. to provide enough power to supply the electromagnetic switch 200 so that the output signal V_{OUT} at X1,X2 may become and remain low, e.g. substantially 0V.

The Inventors have also observed that, if the electromagnetic switch 200 output signal V_{O} switches with low frequencies and/or stops at its low state, the output signal V_{OUT} at terminals X1 and X2 may exhibit glitches or possibly faulty output values (e.g. stopping at a middle value between V_{HI} and V_{LO}, e.g. in a "not allowed" region). Specifically, the Inventors have observed that such malfunctions may occur when the duration of the low resistance state is long, because in this case the electrical storage means C1 will discharge due to the power consumption of the electromagnetic switch 200.

For this reason, if a rotor or impeller (as used e.g. in an arrangement as previously discussed) discontinue rotation when the electromagnetic switch 200 output signal V_{O} is high, e.g. if the substrate 16 stops rotating when the magnet 16a is below the electromagnetic switch 200, then the electrical storage means C1 will discharge.

In such situations, the voltage across the electrical storage means C1 drops below the electromagnetic switch 200 working voltage and the electronic switch T1 may begin to switch between an open and closed condition, possibly uncontrollably. For example, if the electromagnetic switch 200 output signal V_{O} remains high for a time exceeding the discharge time of the electric storage means C1, the power supply at the electromagnetic switch 200 may be discontinued and the electromagnetic switch 200 output signal V_{O} may change to its low state. The electronic switch T1 may thus open slightly (i.e. becoming non-conductive) until the electromagnetic switch 200 is powered up again and its output signal V_{O} can recover its high state, generating e.g. glitches or pulses. The behaviour of the electrical switching circuit under these circumstances may depend on the chosen electromagnetic switch.

Generally, a lowest switching frequency that may be sustained by the electrical switching circuit may be defined by the energy stored in the electrical storage means C1, e.g. a capacitor, and the power consumption of the electromagnetic switch 200.

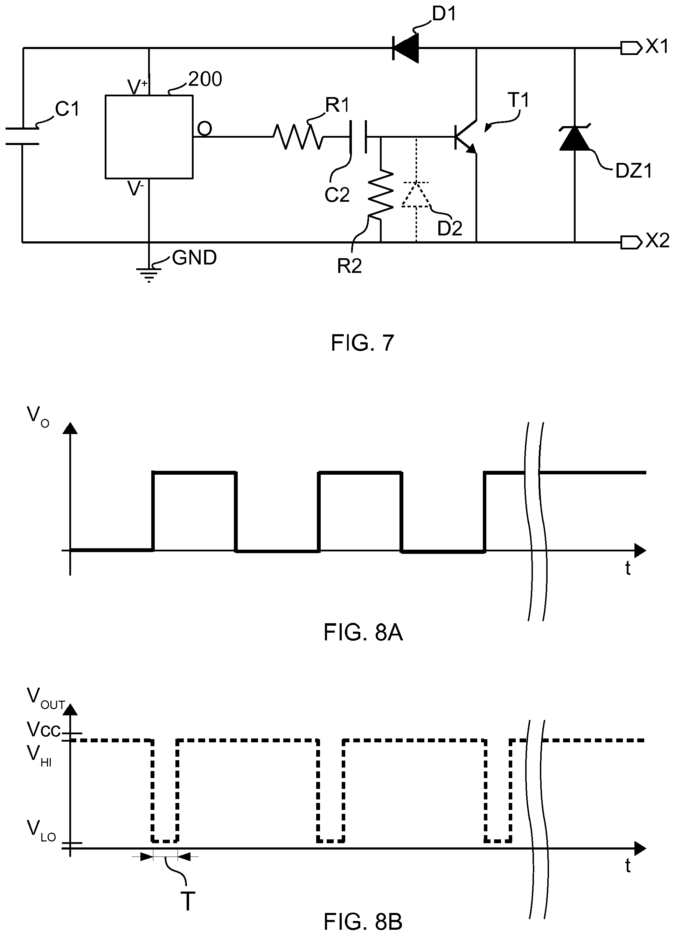

Figure 7 shows thus one embodiment wherein a pulse generator is introduced in order to facilitate overcoming the disadvantages previously outlined. In this regard, Figures 8A and 8B show examples of the signal V_{O} at the output O of the electromagnetic switch 200 and the signal V_{OUT} across the terminals X1/X2, respectively. Generally, in Figures 7, 8A and 8B, the same reference symbols are used to denote parts of elements already introduced in connection with Figures 5, 6A and 6B, and the related description will not be repeated for the sake of brevity.

In the embodiment considered, such a pulse generator may be connected between the output O of the electromagnetic switch 200 and the control terminal of the electronic switch T1, and may produce a pulse when e.g. a rising edge of the switch output signal V_{O} occurs. Generally, the pulse generator may be configured to:
- detect a rising edge and/or a falling edge of the signal V_{O} at the output terminal 0 of the electromagnetic switch 200; and
- when a rising edge and/or a falling edge has been detected, generate a pulse (preferably of a predetermined and fixed duration) applied to the control terminal of the electronic switch T1.

For example, the pulse generator may:
- at a rising edge of the signal V_{O} of the output terminal O of the electromagnetic switch 200, generate a positive voltage pulse at the control terminal of the electronic switch T1; and
- at a falling edge of the signal of the output terminal of the electromagnetic switch 200, generate a negative voltage pulse at the control terminal of the electronic switch T1.

Generally, the pulse generator may be implemented with any suitable circuit, such as a monostable multivibrator.

Conversely, Figure 7 shows the embodiment wherein the pulse generator is exemplified as comprising a capacitor C2, connected in series between the output terminal 0 of the electromagnetic switch 200 and the control terminal of the electronic switch T1, thereby transferring variations of the switch output signal V_{O} at the output terminal 0 of the electromagnetic switch 200 to the control terminal of the electronic switch T1.

In the embodiment, the pulse generator comprises further components connected to the capacitor C2, such as:
- means configured for charging the capacitor C2 at a rising edge of the signal V_{O} of the output terminal O, and
- means configured for discharging the capacitor C2 at a falling edge of the signal V_{O} of the output terminal O.

In the embodiment, the means configured for discharging the capacitor C2 may include e.g. a resistor R2 or, in an alternative embodiment, a diode D2 (exemplified in Figure 7 in parallel to the resistor R2 and in dashed lines) connected (e.g. directly) between the control terminal of the electronic switch T1 and the negative terminal X2, while the means configured for charging the capacitor C2 may include e.g. a resistor R1 connected in series with the capacitor C2 between the output terminal O of the electromagnetic switch 200 and the control terminal of the electronic switch T1.

During a (non-limiting) example of operation of a circuit according to one or more embodiments, the capacitor C2 may begin to charge at the rising edge of the switch output signal V_{O}. While the capacitor C2 charges, a pulse may be generated, which may close the electronic switch T1 (that is, make it conductive): the output signal V_{OUT} at the terminals X1 and X2 may change to a low state, as depicted in Figure 8B, for a time period T being a function of the pulse generated by the pulse generator, e.g. depending on the capacitor C2 charge time.

For example, in various embodiments, the resistors R1 and R2 may be between 5 and 200 kΩ, preferably between 10 and 100 kΩ, more preferably between 20 and 50 kΩ, e.g. 33 kΩ. The capacitor C2 may be in between 100 nF and 2 uF, preferably between 200 and 600 nF, e.g. 470 nF.

When the capacitor C2 has been charged, its voltage may saturate at peak voltage of the switch output signal V_{O} and the pulse decays to zero. The electronic switch T1 may therefore be opened, discontinuing the short circuit between terminals X1 and X2.

The time period T of the low state of the output signal V_{OUT} at terminals X1 and X2 may depend on the pulse generated by the pulse generator which in turn may be set to a predetermined value depending on the components of the circuit, e.g. in one or more embodiments the pulse duration is determined by the values of the capacitance C2 and resistances R1,R2.

The pulse may have a given profile for closing the electronic switch for the time period T, so that:
- the time period T may be smaller than the discharge time of the electrical storage means C1; and/or
- the generated low value at the terminals X1 and X2 is long enough that it may be recognized by e.g. a processing unit connected to the electrical switching circuit; and/or
- the time period T may be smaller than the upper peak frequency expected by the switch output signal V_{O} (which may depend on the rotation frequency).

It will be noticed that, if the profile of the pulse is squared, the time period T of the output signal V_{OUT} may be substantially the same period of the pulse. If however the profile is different, e.g. a pulse decaying exponentially, the time period T may depend on a time window wherein the voltage is higher than the switching voltage at the control terminal, e.g. the lower bound voltage which may close (i.e. make conductive) the electronic switch T1.

In one or more embodiments, as illustrated in Figure 8B, at the end of the time period T, the output signal V_{OUT} at the terminals X1 and X2 returns high, i.e. substantially Vcc. When the magnetic field changes the switch output signal V_{O} to its low state, the output signal V_{OUT} may be already at its high state V_{HI}, and the cycle may be repeated when e.g. a new rising edge of the switch output signal V_{O} occurs.

The output signal V_{OUT} across terminals X1 and X2 of Figure 8B may be considered as substantially representative of an output signal in case of e.g. a conventional reed switch, with minor differences:
- the frequency of the output signal of the electrical switching circuit according to one or more embodiments may not exhibit a 50% duty cycle; and/or
- idle state may be possible at the high value of the output signal across terminals X1 and X2.

In one or more embodiments, therefore, the electrical switching circuit may allow a digital "rail-to-rail" output signal, which may be used as a replacement of e.g. a reed switch. This may be due to the presence of the electrical storage means C1 and the diode D1, which may prevent superfluous discharge thereof, e.g. by discharging via the electronic switch T1 when it is conductive.

In one or more embodiments, the electrical storage means C1 may be dimensioned in order to provide power supply to the electromagnetic switch 200 for the time that the switch output signal V_{O} remains low.

Moreover, in one or more embodiments, a pulse generator is included, that facilitates dealing with operating conditions wherein the rotation frequency (and thus the switch output signal V_{O} frequency) is low and/or wherein the rotation stops with the switch output signal V_{O} being high. In such situations, the output signal V_{OUT} across the terminals X1 and X2 may exhibit certain glitches and/or may remain in a "not allowed" region.

With the presence of a pulse generator, e.g. a capacitor C2 plus resistors R1,R2, the signal driving the control terminal of the electronic switch T1 may be set to a predefined limited duration, and the output signal V_{OUT} across the terminals X1 and X2 may be in turn limited to a predefined time period, e.g. T.

In one or more embodiments, the electrical storage means may be dimensioned according to the duration of the pulse generated by the pulse generator: in a non-limiting example a capacitor C1, included in the electrical storage means, may be dimensioned in order to be bigger than the capacitor C2, included in the pulse generator.

One or more embodiments including a pulse generator may exhibit one or more of the following advantages:
- a digital output, compatible with e.g. digital input devices; and/or
- substantially rail-to-rail operations - e.g. CMOS and TTL compatible outputs; and/or
- no need for additional signal conditioning; and/or
- pin to pin exchange with e.g. reed switches, without changes on e.g. mother board part; and/or
- the electrical switching circuit works also in situations wherein the impeller (or rotor) may rotate at a low speed and/or may stall in ON state (i.e. high value at the output terminal e.g. O of the electromagnetic switch 200); and/or
- smaller electrical storage means e.g. C1 compared to electrical switching circuits not including a pulse generator: the pulse (e.g. the pulse generated by the capacitor C2 at the control terminal of the electronic switch T1) may be dimensioned as being significantly

shorter than the time that the switch output signal V_{O} remains high, therefore in embodiments including the pulse generator the electrical storage means may be significantly smaller than in embodiments wherein the pulse generator may be absent.

The extent of protection is defined by the annexed claims.

## Claims

1. An electrical switching circuit, including:
- a first (X1) and a second (X2) terminal;
- an electromagnetic switch (200) having a positive (V+) and a negative (V-) power supply terminal and an output terminal (0), said negative (V-) power supply terminal being connected to said second (X2) terminal;
- an electronic switch (T1) connected between said first (X1) and said second (X2) terminal, wherein said electronic switch (T1) switches between an opened and a closed condition as a function of a signal applied to a control terminal of said electronic switch (T1), wherein said control terminal of said electronic switch (T1) is connected to the output (0) of said electromagnetic switch (200), thereby varying the resistance between said first (X1) and said second (X2) terminal,
wherein said electrical switching circuit includes:
- electrical storage means (C1), connected between said positive (V+) and said negative (V-) power supply terminal of said electromagnetic switch (200); and
- a diode (D1), wherein the cathode of said diode (D1) is connected to said positive power supply terminal (V+) of said electromagnetic switch (200) and the anode of said diode (D1) is connected to said first (X1) terminal, whereby:
- when the voltage (V_{OUT}) between said first (X1) and said second (X2) terminal is greater than the voltage between said positive (V+) and said negative (V-) power supply terminal of said electromagnetic switch (200), said diode (D1) is closed and the voltage (V_{OUT}) between said first (X1) and said second (X2) terminal supplies power to said electromagnetic switch (200) and charges said electrical storage means (C1), and
- when the voltage (V_{OUT}) between said first (X1) and said second (X2) terminal is smaller than the voltage between said positive (V+) and said negative (V-) power supply terminal of said electromagnetic switch (200), said diode (D1) is opened and said electrical storage means (C1) supply power to said electromagnetic switch (200); wherein the electrical switching circuit further comprises a pulse generator set between the output terminal (0) of the electromagnetic switch (200) and said control terminal of said electronic switch (T1), wherein said pulse generator is configured to:
- detect a rising edge and/or a falling edge of the signal (VO) at the output terminal (0) of the electromagnetic switch (200); and
- when a rising edge and/or a falling edge has been detected, generate a pulse applied to said control terminal of said electronic switch (T1); wherein said pulse generator is moreover configured to:
- at a rising edge of the signal (VO) of the output terminal (0) of the electromagnetic switch (200), generate a positive pulse at said control terminal of said electronic switch (T1); and
- at a falling edge of the signal (VO) of the output terminal (0) of the electromagnetic switch (200), generate a negative pulse at said control terminal of said electronic switch (T1).

2. The electrical switching circuit of Claim 1, wherein said electronic switch (T1) is configured to short circuit said first (X1) and said second (X2) terminal in said closed condition.

3. The electrical switching circuit of Claim 1, wherein said pulse has a given profile for closing said electronic switch (T1) for a given time period (T).

4. The electrical switching circuit of Claim 3, wherein said given time period (T) is smaller than the discharge time of said electrical storage means (C1).

5. The electrical switching circuit of any of the preceding Claims, wherein said pulse generator includes:
- a capacitor (C2) connected between the output (0) of said electromagnetic switch (200) and said control terminal of said electronic switch (T1),
- means for charging (R1) said capacitor (C2) at a rising edge of the signal (V_{O}) of the output terminal (0), and
- means for discharging (R2, D2) said capacitor (C2) at a falling edge of the signal (V_{O}) of the output terminal (0) .

6. The electrical switching circuit of Claims 5, wherein said pulse generator includes:
- a first resistor (R2) or a further diode (D2) connected between said control terminal of said electronic switch (T1) and said second (X2) terminal, and
- a second resistor (R1) connected in series with said capacitor (C2) between the output of said electromagnetic switch (200) and said control terminal of said electronic switch (T1).

7. The electrical switching circuit of any of the previous claims, wherein said electromagnetic switch (200) is a Hall effect switch or a magneto-resistive switch.

8. The electrical switching circuit of any of the previous claims, wherein the electronic switch (T1) is a transistor, preferably a bipolar transistor.

9. The electrical switching circuit of any of the previous claims, wherein said electrical storage means (C1) include a capacitor connected between said positive (V+) and said negative (V-) power supply terminal of said electromagnetic switch (200).

10. The electrical switching circuit of any of the previous claims, including at least one Zener diode (DZ1), connected between said first (X1) and said second (X2) terminal.

11. An apparatus, such as a dishwasher, including:
- an electrical switching circuit according to any of the previous claims, and
- a processing unit configured to:
- apply a voltage (Vcc) via a pull-up resistor to said first (X1) and a ground to said second (X2) terminal of said electrical switching circuit; and
- monitoring the voltage at said first (X1) and said second (X2) terminal of said electrical switching circuit.

12. A method of monitoring a time varying magnetic field, comprising:
- providing an electrical switching circuit according to any of claims 1 to 10, and
- exposing the electromagnetic switch (200) of said electrical switching circuit to said time varying magnetic field.

13. The method of Claim 12, comprising:
- detecting a rising edge and/or a falling edge of the signal (V_{O}) at the output terminal (0) of the electromagnetic switch (200) of said electrical switching circuit; and
- when a rising edge and/or a falling edge has been detected, closing the electronic switch (T1) of said electrical switching circuit for a given time period (T).

## Patentansprüche

1. Elektrischer Schaltkreis, aufweisend:
- einen ersten (X1) und einen zweiten (X2) Anschluss;
- einen elektromagnetischen Schalter (200) mit einem positiven (V+) und einem negativen (V-) Stromversorgungsanschluss und einem Ausgangsanschluss (O), wobei der negative (V-) Stromversorgungsanschluss mit dem zweiten (X2) Anschluss verbunden ist;
- einen elektronischen Schalter (T1), der zwischen dem ersten (X1) und dem zweiten (X2) Anschluss verbunden ist, wobei der elektronische Schalter (T1) zwischen einem geöffneten und einem geschlossenen Zustand umschaltet in Abhängigkeit von einem an einen Steueranschluss des elektronischen Schalters (T1) angelegten Signal, wobei der Steueranschluss des elektronischen Schalters (T1) mit dem Ausgang (O) des elektromagnetischen Schalters (200) verbunden ist, wodurch der Widerstand zwischen dem ersten (X1) und dem zweiten (X2) Anschluss variiert wird,
wobei der elektrische Schaltkreis aufweist:
- elektrische Speichermittel (C1), die zwischen dem positiven (V+) und dem negativen (V-) Stromversorgungsanschluss des elektromagnetischen Schalters (200) verbunden sind; und
- eine Diode (D1), wobei die Kathode der Diode (D1) mit dem positiven Stromversorgungsanschluss (V+) des elektromagnetischen Schalters (200) verbunden ist und die Anode der Diode (D1) mit dem ersten (X1) Anschluss verbunden ist, wobei:
- wenn die Spannung (V_{OUT}) zwischen dem ersten (X1) und dem zweiten (X2) Anschluss größer als die Spannung zwischen dem positiven (V+) und dem negativen (V-) Stromversorgungsanschluss des elektromagnetischen Schalters (200) ist, die Diode (D1) geschlossen wird, und die Spannung (V_{OUT}) zwischen dem ersten (X1) und dem zweiten (X2) Anschluss den elektromagnetischen Schalter (200) mit Strom versorgt und die elektrischen Speichermittel (C1) auflädt, und
- wenn die Spannung (V_{OUT}) zwischen dem ersten (X1) und dem zweiten (X2) Anschluss kleiner als die Spannung zwischen dem positiven (V+) und dem negativen (V-) Stromversorgungsanschluss des elektromagnetischen Schalters (200) ist, die Diode (D1) geöffnet wird, und die elektrischen Speichermittel (C1) den elektromagnetischen Schalter (200) mit Strom versorgen; wobei der elektrische Schaltkreis ferner einen Impulsgenerator umfasst, der zwischen dem Ausgangsanschluss (O) des elektromagnetischen Schalters (200) und dem Steueranschluss des elektronischen Schalters (T1) gesetzt ist, wobei der Impulsgenerator ausgelegt ist zum:
- Erkennen einer ansteigenden Flanke und/oder einer abfallenden Flanke des Signals (VO) an dem Ausgangsanschluss (O) des elektromagnetischen Schalters (200); und
- wenn eine ansteigende Flanke und/oder eine abfallende Flanke erkannt wurde, Erzeugen eines Impulses, der an den Steueranschluss des elektronischen Schalters (T1) angelegt wird; wobei der Impulsgenerator außerdem ausgelegt ist zum:
- bei einer ansteigenden Flanke des Signals (VO) des Ausgangsanschlusses (O) des elektromagnetischen Schalters (200), Erzeugen eines positiven Impulses an dem Steueranschluss des elektronischen Schalters (T1); und
- bei einer fallenden Flanke des Signals (VO) des Ausgangsanschlusses (O) des elektromagnetischen Schalters (200), Erzeugen eines negativen Impulses an dem Steueranschluss des elektronischen Schalters (T1).

2. Elektrischer Schaltkreis nach Anspruch 1, wobei der elektronische Schalter (T1) dazu ausgelegt ist, den ersten (X1) und den zweiten (X2) Anschluss in dem geschlossenen Zustand kurzzuschließen.

3. Elektrischer Schaltkreis nach Anspruch 1, wobei der Impuls ein gegebenes Profil zum Schließen des elektronischen Schalters (T1) für eine gegebene Zeitperiode (T) hat.

4. Elektrischer Schaltkreis nach Anspruch 3, wobei die gegebene Zeitperiode (T) kleiner als die Entladezeit der elektrischen Speichermittel (C1) ist.

5. Elektrischer Schaltkreis nach einem der vorhergehenden Ansprüche, wobei der Impulsgenerator aufweist:
- einen Kondensator (C2), der zwischen dem Ausgang (O) des elektromagnetischen Schalters (200) und dem Steueranschluss des elektronischen Schalters (T1) verbunden ist;
- Mittel zum Aufladen (R1) des Kondensators (C2) bei einer ansteigenden Flanke des Signals (V_{O}) des Ausgangsanschlusses (O), und
- Mittel zum Entladen (R2, D2) des Kondensators (C2) bei einer fallenden Flanke des Signals (V_{O}) des Ausgangsanschlusses (O).

6. Elektrischer Schaltkreis nach Anspruch 5, wobei der Impulsgenerator aufweist:
- einen ersten Widerstand (R2) oder eine weitere Diode (D2), die zwischen dem Steueranschluss des elektronischen Schalters (T1) und dem zweiten (X2) Anschluss verbunden ist, und
- einen zweiten Widerstand (R1), der in Reihe mit dem Kondensator (C2) zwischen dem Ausgang des elektromagnetischen Schalters (200) und dem Steueranschluss des elektronischen Schalters (T1) verbunden ist.

7. Elektrischer Schaltkreis nach einem der vorherigen Ansprüche, wobei der elektromagnetische Schalter (200) ein Hall-Effekt-Schalter oder ein magnetoresistiver Schalter ist.

8. Elektrischer Schaltkreis nach einem der vorherigen Ansprüche, wobei der elektronische Schalter (T1) ein Transistor, vorzugsweise ein Bipolartransistor, ist.

9. Elektrischer Schaltkreis nach einem der vorherigen Ansprüche, wobei die elektrischen Speichermittel (C1) einen Kondensator aufweisen, der zwischen dem positiven (V+) und dem negativen (V-) Stromversorgungsanschluss des elektromagnetischen Schalters (200) verbunden ist.

10. Elektrischer Schaltkreis nach einem der vorherigen Ansprüche, der mindestens eine Zenerdiode (DZ1) aufweist, die zwischen dem ersten (X1) und dem zweiten (X2) Anschluss verbunden ist.

11. Vorrichtung, wie beispielsweise ein Geschirrspüler, aufweisend:
- einen elektrischen Schaltkreis nach einem der vorherigen Ansprüche, und
- eine Verarbeitungseinheit, die ausgelegt ist zum:
- Anlegen einer Spannung (V_{CC}) über einen Pullup-Widerstand an den ersten (X1) und einer Masse an den zweiten (X2) Anschluss des elektrischen Schaltkreises; und
- Überwachen der Spannung an dem ersten (X1) und dem zweiten (X2) Anschluss des elektrischen Schaltkreises.

12. Verfahren zur Überwachung eines zeitlich variierenden Magnetfelds, umfassend:
- Bereitstellen eines elektrischen Schaltkreises gemäß einem der Ansprüche 1 bis 10, und
- Aussetzen des elektromagnetischen Schalters (200) des elektrischen Schaltkreises dem zeitlich variierenden Magnetfeld.

13. Verfahren nach Anspruch 12, umfassend:
- Erkennen einer ansteigenden Flanke und/oder einer abfallenden Flanke des Signals (V_{O}) an dem Ausgangsanschluss (O) des elektromagnetischen Schalters (200) des elektrischen Schaltkreises; und
- wenn eine ansteigende Flanke und/oder eine abfallende Flanke erkannt wurde, Schließen des elektronischen Schalters (T1) des elektrischen Schaltkreises für eine gegebene Zeitperiode (T).

## Revendications

1. Circuit de commutation électrique, comportant :
- des première (X1) et une seconde (X2) bornes ;
- un commutateur électromagnétique (200) présentant des bornes d'alimentation électrique positive (V+) et négative (V-) ainsi qu'une borne de sortie (O), ladite borne d'alimentation électrique négative (V-) étant connectée à ladite seconde borne (X2) ;
- un commutateur électronique (T1) connecté entre lesdites première (X1) et seconde (X2) bornes, ledit commutateur électronique (T1) commutant entre un état ouvert et en état fermé en fonction d'un signal appliqué à une borne de commande dudit commutateur électronique (T1), dans lequel ladite borne de commande dudit commutateur électronique (T1) est connectée à la sortie (O) dudit commutateur électromagnétique (200), modifiant ainsi la résistance entre lesdites première (X1) et seconde (X2) bornes,
ledit circuit de commutation électrique comportant :
- un moyen de stockage électrique (C1) connecté entre lesdites bornes d'alimentation électrique positive (V+) et négative (V-) dudit commutateur électromagnétique (200) ; et
- une diode (D1) la cathode de ladite diode (D1) étant connectée à la petite borne d'alimentation électrique positive (V+) dudit commutateur électromagnétique (200) et l'anode de ladite diode (D1) étant connectée à ladite première borne (X1), moyennant quoi :
- quand la tension (V_{OUT}) entre lesdites première (X1) et seconde (X2) bornes est supérieure à la tension entre lesdites bornes d'alimentation électrique positive (V+) et négative (V-) dudit commutateur électromagnétique (200), ladite diode (D1) est fermée et la tension (V_{OUT}) entre lesdites première (X1) et seconde (X2) bornes alimente en puissance ledit commutateur électromagnétique (200) et charge ledit moyen de stockage électrique (C1), et
- quand la tension (V_{OUT}) entre lesdites première (X1) et seconde (X2) bornes est inférieure à la tension entre lesdites bornes d'alimentation électrique positive (V+) et négative (V-) dudit commutateur électromagnétique (200), ladite diode (D1) est ouverte et ledit moyen de stockage électrique (C1) alimente en puissance ledit commutateur électromagnétique (200) ; le circuit de commutation électrique comprenant en outre un générateur d'impulsions monté entre la borne de sortie (O) du commutateur électromagnétique (200) et ladite borne de commande dudit commutateur électronique (T1), ledit générateur d'impulsion étant configuré pour :
- détecter un flanc montant et/ou un flanc descendant du signal (VO) à la borne de sortie (O) du commutateur électromagnétique (200) ; et
- quand un flanc montant et/ou un flanc descendant a été détecté, générer une pulsion appliquée à ladite borne de commande dudit commutateur électronique (T1) ; dans lequel ledit générateur d'impulsions est configuré en outre pour :
- lors d'un flanc montant du signal (VO) de la borne de sortie (O) du commutateur électromagnétique (200), générer une impulsion positive à ladite borne de commande dudit commutateur électronique (T1) ; et
- lors d'un flanc descendant du signal (VO) de la borne de sortie (O) du commutateur électromagnétique (200) générer une impulsion négative à ladite borne de commande dudit commutateur électronique (T1) .

2. Circuit de commutation électrique selon la revendication 1, dans lequel ledit commutateur électronique (T1) est configuré pour court-circuiter lesdites première (X1) et seconde (X2) bornes dans ladite position fermée.

3. Circuit de commutation électrique selon la revendication 1, dans lequel ladite impulsion a un profil donné pour fermer ledit commutateur électronique (T1) pendant une période de temps donnée (T).

4. Circuit de commutation électrique selon la revendication 3, dans lequel ladite période de temps donnée (T) est plus courte que le temps de décharge dudit moyen de stockage électrique (C1).

5. Circuit de commutation électrique selon l'une quelconque des revendications précédentes dans lequel ledit générateur d'impulsions comporte :
- un condensateur (C2) connecté entre la sortie (O) dudit commutateur électromagnétique (200) et ladite borne de commande dudit commutateur électronique (T1),
- un moyen de charge (R1) dudit condensateur (C2) lors d'un flanc montant du signal (Vo) de la borne de sortie (O), et
- un moyen de décharge (R2, D2) dudit condensateur (C2) lors d'un flanc descendant du signal (Vo) de la borne de sortie (O).

6. Circuit de commutation électrique selon les revendications 5, dans lequel ledit générateur d'impulsion comporte :
- une première résistance (R2) ou une autre diode (D2) connectée entre ladite borne de commande dudit commutateur électronique (T1) et ladite seconde borne (X2), et
- une seconde résistance (R1) connectée en série avec ledit condensateur (C2) entre la sortie dudit commutateur électromagnétique (200) et ladite borne de commande dudit commutateur électronique (T1).

7. Circuit de commutation électrique selon l'une quelconque des revendications précédentes, dans lequel ledit commutateur électromagnétique (200) est un commutateur à effet de Hall ou un commutateur magnéto-résistif.

8. Circuit de commutation électrique selon l'une quelconque des revendications précédentes, dans lequel le commutateur électronique (T1) est un transistor, de préférence un transistor bipolaire.

9. Circuit de commutation électrique selon l'une quelconque des revendications précédentes, dans lequel ledit moyen de stockage électrique (C1) comporte un condensateur connecté entre lesdites bornes d'alimentation électrique positive (V+) et négative (V-) dudit commutateur électromagnétique (200) .

10. Circuit de commutation électrique selon l'une quelconque des revendications précédentes, comportant au moins une diode Zener (DZ1) connectée entre lesdites première (X1) et seconde (X2) bornes.

11. Appareil, tel qu'un lave-vaisselle, comportant :
- un circuit de commutation électrique selon l'une quelconque des revendications précédentes, et
- une unité de traitement configurée pour :
- appliquer une tension (Vcc) par l'intermédiaire d'une résistance d'excursion haute à ladite première borne (X1) et une masse à ladite seconde borne (X2) dudit circuit de commutation électrique ; et
- surveiller la tension auxdites première (X1) et seconde (X2) bornes dudit circuit de commutation électrique.

12. Procédé de surveillance d'un champ magnétique variant dans le temps, comprenant :
- la fourniture d'un circuit de commutation électrique selon l'une quelconque des revendications 1 à 10, et
- l'exposition du commutateur électromagnétique (200) dudit circuit de commutation électrique audit champ magnétique variant dans le temps.

13. Procédé selon la revendication 12, comprenant :
- la détection d'un flanc montant et/ou d'un flanc descendant du signal (Vo) au niveau de la borne de sortie (O) du commutateur électromagnétique (200) dudit circuit de commutation électrique ; et
- quand un flanc montant et/ou un flanc descendant a été détecté, la fermeture du commutateur électronique (T1) dudit circuit de commutation électrique pendant une période de temps donnée (T).
